# EUROPÄISCHE PATENTSCHRIFT

(11) **EP 1 643 567 B1**
(45) Veröffentlichungstag und Bekanntmachung des Hinweises auf die Patenterteilung: **06.05.2015**
(21) Anmeldenummer: 05018724.4
(22) Anmeldetag: 29.08.2005
(51) Int. Cl.: H01L 33/50

(54) **Lumineszenzdiodenchip mit einer Konverterschicht und Verfahren zur Herstellung eines Lumineszenzdiodenchips mit einer Konverterschicht**
Light emitting diode chip with conversion layer and method of manufacturing the same
Puce à diode électroluminescente avec couche de conversion et son procédé de fabrication

(30) Priorität: 30.09.2004 DE 102004047727
(43) Veröffentlichungstag der Anmeldung: 05.04.2006
(73) Patentinhaber: OSRAM Opto Semiconductors GmbH, 93055 Regensburg (DE)
(72) Erfinder: Richter, Markus, 93073 Neutraubling (DE); Eberhard, Franz, 93059 Regensburg (DE); Holzer, Peter, 93083 Obertraubling (DE); Guenther, Ewald Karl Michael, 93128 Regenstauf (DE)
(74) Vertreter: Epping - Hermann - Fischer

(56) Entgegenhaltungen:
- EP-A- 1 394 867
- WO-A-01/69692
- US-B1- 6 472 765
- US-B1- 6 747 406

## Beschreibung

Diese Patentanmeldung beansprucht die Priorität der deutschen Patentanmeldung 10 2004 047 727.2, deren Offenbarungsgehalt hiermit durch Rückbezug aufgenommen wird.

Die Erfindung betrifft einen Lumineszenzdiodenchip mit einer Halbleiterschichtenfolge und einer Konverterschicht gemäß dem Oberbegriff von Anspruch 1 sowie ein Verfahren zum Herstellen eines derartigen Lumineszenzdiodenchips gemäß dem Oberbegriff von Anspruch 12.

Es ist bekannt, Lumineszenzdiodenchips zur Bildung von optoelektronischen Bauelementen mittels einer Vergussmasse einzukapseln, in die ein Lumineszenzkonversionsmaterial mit mindestens einem Leuchtstoff gemischt ist. Das Einkapseln erfolgt z.B. durch Vergießen einer Gehäusekavität, in der ein Lumineszenzdiodenchip montiert ist, oder durch Umspritzen eines auf einem Leiterrahmen montierten Lumineszenzdiodenchips mittels Spritzpressen.

Bei einer Verwendung derartiger Vergussmassen kann es zu Farbortschwankungen aufgrund einer inhomogenen Verteilung des Leuchtstoffes in der Vergussmasse kommen, die z.B. auf einer Sedimentationsbildung von Leuchtstoffpartikeln beruhen kann. Zudem gibt es Fertigungstoleranzen bezüglich einer Dosierbarkeit der Vergussmasse, der Höhen von Lumineszenzdiodenchips und/oder einer Positionierbarkeit der Lumineszenzdiodenchips in der Kavität eines Spritzwerkzeugs. Dies kann zu signifikanten Schwankungen der Menge der Vergussmasse, die dem Lumineszenzdiodenchip in einer Abstrahlrichtung nachgeordnet ist, und somit auch zu Schwankungen des Farbortes des Bauelements führen.

In der WO 01/65613 A1 ist offenbart, eine dünne Konverterschicht mit mindestens einem Leuchtstoff direkt auf einer Halbleiterschichtenfolge eines Lumineszenzdiodenchips aufzubringen. Dies hat gegenüber der Verwendung von leuchtstoffhaltigen Vergussmassen den Vorteil, dass Leuchtstoffe homogener und in einer besser definierbaren Menge auf der Halbleiterschichtenfolge des Lumineszenzdiodenchips aufgebracht werden können. Ein von derart hergestellten Lumineszenzdiodenchips emittiertes Licht weist hinsichtlich seines Farbortspektrums in der Regel eine größere Homogenität auf als Bauelemente, bei denen ein Lumineszenzdiodenchip mit einer leuchtstoffhaltigen Vergussmasse eingekapselt ist.

In der Druckschrift US 6,747,406 B1 ist eine LED angegeben, bei der eine Phosphordicke mit einer lokal emittierten Strahlungsintensität korreliert ist.

Eine Leuchtdiode sowie eine Herstellungsmethode für diese Leuchtdiode sind in der Druckschrift EP 1 394 867 A2 offenbart.

Die Druckschrift WO 01/69692 A1 betrifft eine Leuchtdiode, ein Licht emittierendes Bauteil und eine Herstellungsmethode hierfür.

Ein Licht emittierendes Halbleiterbauteil mit einer Kunststoffverkapselung und mit einer Beschichtung mit fluoreszierenden Partikeln ist in der Druckschrift US 6,472,765 B1 beschrieben.

Es ist eine Aufgabe der vorliegenden Erfindung, einen Lumineszenzdiodenchip der eingangs genannten Art bereitzustellen, der, verglichen mit herkömmlichen derartigen Lumineszenzdiodenchips, hinsichtlich eines gewünschten Farbortspektrums verbesserte Eigenschaften aufweist und mit dem es insbesondere möglich ist, ein Farbortspektrum mit weitergehend vergrößerter Homogenität zu realisieren. Zudem soll ein Verfahren zur Herstellung eines derartigen Lumineszenzdiodenchips angegeben werden.

Diese Aufgabe wird durch einen Lumineszenzdiodenchip mit den Merkmalen des Anspruchs 1 bzw. durch ein Verfahren mit den Merkmalen des Anspruchs 6 gelöst. Vorteilhafte Ausführungsformen und bevorzugte Weiterbildungen des Lumineszenzdiodenchips und des Verfahrens sind Gegenstand der abhängigen Patentansprüche.

Erfindungsgemäß ist die Konverterschicht des Lumineszenzdiodenchips gezielt zur Einstellung einer Abhängigkeit des resultierenden Farbortes von einem Betrachtungswinkel strukturiert.

"Strukturiert" ist die Konverterschicht im Sinne der Erfindung dann, wenn die Hauptfläche Teilbereiche aufweist, die frei von der Konverterschicht sind und/oder auf denen die Konverterschicht eine gegenüber übrigen Bereichen auf der Hauptfläche verringerte Dicke aufweist. Statistische Schwankungen in der Dicke von schichtartig aufgebrachten Konverterschichten sind dabei nicht als Strukturierungen im Sinne der Erfindung anzusehen.

Unter einem "Betrachtungswinkel" ist im Sinne der Erfindung ein Winkel zwischen einer Betrachtungsrichtung auf den Lumineszenzdiodenchip und der Normalen zu einer Haupterstreckungsebene der Hauptfläche zu verstehen.

Die Konverterschicht liegt auf der Hauptfläche nicht in einer möglichst homogenen Form vor, sondern sie ist gezielt derart strukturiert, dass unterschiedliche Teilbereiche der Hauptfläche geeignet sind, Licht mit unterschiedlichen Farbörtern zu emittieren. Dieses Licht der unterschiedlichen Teilbereiche der Hauptfläche überlagert sich in einem für einen Beobachter wahrnehmbaren Fernfeld zumindest zum Teil, so dass die Abhängigkeit des Farbortes von dem Beobachtungswinkel auf vielfältige Weise eingestellt sein kann.

Bei Bauelementen mit herkömmlichen Lumineszenzdiodenchips wurde festgestellt, dass der resultierende Farbort selbst dann noch eine signifikante Abhängigkeit vom Betrachtungswinkel aufweist, wenn die Halbleiterschichtenfolge des Lumineszenzdiodenchips im wesentlichen mit einer dünnen, möglichst homogenen und ganzflächig auf der Hauptfläche der Halbleiterschichtenfolge aufgebrachten Konverterschicht versehen ist. In einer bevorzugten Ausführungsform des Lumineszenzdiodenchips ist die Konverterschicht derart strukturiert, dass die Abhängigkeit des resultierenden Farbortes von dem Betrachtungswinkel, verglichen mit einer unstrukturierten Konverterschicht herkömmlicher Lumineszenzdiodenchips, verringert ist.

Die Konverterschicht ist mit Vorteil an einem Rand des Lumineszenzdiodenchips strukturiert. Durch eine derartige Strukturierung der Konverterschicht am Rand wird insbesondere der Farbort, der unter relativ großen Beobachtungswinkeln wahrnehmbar ist, beeinflusst.

Bevorzugt ist die Konverterschicht dabei derart strukturiert, dass die Hauptfläche einen Streifen aufweist, der entlang dem Rand des Lumineszenzdiodenchips verläuft und auf dem die Konverterschicht strukturiert ist. D.h. der Streifen ist frei von der Konverterschicht oder die Konverterschicht weist auf dem Streifen eine gegenüber ihren übrigen Bereichen auf der Hauptfläche verringerte Dicke auf. Der Streifen umschließt besonders bevorzugt einen Bereich der Hauptfläche, auf dem die Konverterschicht unstrukturiert ist, d.h. er bildet einen Rahmen.

In einer vorteilhaften Ausführungsform des Lumineszenzdiodenchips weist der Streifen bevorzugt eine Breite von größer als 0 µm und von maximal einem Zehntel einer Kantenlänge des Lumineszenzdiodenchips auf.

Der Lumineszenzdiodenchip ist mit besonderem Vorteil ein Dünnfilm-Lumineszenzdiodenchip. Ein Dünnfilm-Lumineszenzdiodenchip zeichnet sich insbesondere durch folgende charakteristische Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20*µ*m oder weniger, insbesondere im Bereich von 10 *µ*m auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Leuchtdiodenchip ist in guter Näherung ein Lambert'scher Oberflächenstrahler, dessen Halbleiterschichtenfolge die Primärstrahlung im wesentlichen über die Hauptfläche emittiert, so dass sich eine hinsichtlich des Farbortes gewünschte Abstrahlcharakteristik bei derartigen Leuchtdiodenchips besonders gut durch Aufbringen einer strukturierten Konverterschicht auf die Hauptfläche realisieren lässt.

Die Konverterschicht weist bevorzugt Silikon auf. Dieses ist gegenüber ultravioletter Strahlung weitestgehend unempfindlich und somit insbesondere im Zusammenhang mit Halbleiterschichtenfolgen geeignet, die eine Primärstrahlung aus einem ultravioletten Wellenlängenbereich emittieren.

In einer vorteilhaften Ausführungsform weist die Konverterschicht eine Dicke auf, die größer als 0 *µ*m und maximal 50 *µ*m dick ist.

Zur Einstellung einer Abhängigkeit der Intensität der Primärstrahlung von dem Betrachtungswinkel sind in der Halbleiterschichtenfolge bevorzugt Auskoppelstrukturen ausgebildet. Durch derartige Maßnahmen lässt sich die Abhängigkeit des resultierenden Farbortes von dem Betrachtungswinkel weitergehend wunschgemäß beeinflussen.

Zusätzlich oder alternativ ist auf der Konverterschicht eine Auskoppelschicht angeordnet, in der zur Einstellung einer Abhängigkeit der Intensität der Mischstrahlung von dem Betrachtungswinkel Auskoppelstrukturen ausgebildet sind.

Die Auskoppelstrukturen, die in der Halbleiterschichtenfolge und/oder in der Auskoppelschicht ausgebildet sind, umfassen bevorzugt prismenartige Elemente.

Bei dem Verfahren der eingangs genannten Art wird erfindungsgemäß die Halbleiterschichtenfolge bereitgestellt und die Hauptfläche der Halbleiterschichtenfolge mit der Konverterschicht versehen, wobei die Konverterschicht gezielt zur Einstellung einer Abhängigkeit des resultierenden Farbortes von einem Betrachtungswinkel strukturiert wird. Das Strukturieren der Konverterschicht kann durch ein strukturiertes Aufbringen von dieser oder durch ein ganzflächiges Aufbringen und ein nachfolgendes Strukturieren erfolgen.

Die Konverterschicht wird besonders bevorzugt durch ein strukturiertes Aufbringen mittels eines Siebdruckverfahrens strukturiert.

Alternativ wird die Konverterschicht mit Vorteil auf die Hauptfläche aufgebracht und nachfolgend strukturiert. Dies erfolgt bevorzugt mittels eines lithografischen Prozesses.

Weitere Vorteile, bevorzugte Ausführungsformen und Weiterbildungen des Lumineszenzdiodenchips und des Verfahrens ergeben sich aus den im Folgenden in Verbindung mit den Figuren 1a bis 8 erläuterten Ausführungsbeispielen. Es zeigen:
- Figur 1a: eine schematische Darstellung einer Draufsicht eines Lumineszenzdiodenchips gemäß des Standes der Technik,
- Figur 1b: eine schematische Schnittansicht des in Figur 1a dargestellten Lumineszenzdiodenchips in einem Schnitt entlang der gestrichelten Linie AB,
- Figur 1c: gemessene Farbortkoordinaten der CIE-Farbtafel in Auftragung gegen den Betrachtungswinkel eines von dem in den Figuren 1a und 1b dargestellten Lumineszenzdiodenchips emittierten Lichtes,
- Figur 1d: die Strahlungsintensität des von den in Figuren 1a und 1b dargestellten Lumineszenzdiodenchips emittierten Lichtes in Abhängigkeit von dem Beobachtungswinkel,
- Figur 2a: eine schematische Darstellung einer Draufsicht auf einen Lumineszenzdiodenchip gemäß eines ersten Ausführungsbeispiels,
- Figur 2b: eine schematische Schnittansicht des in Figur 2a dargestellten Lumineszenzdiodenchips in einem Schnitt entlang der gestrichelten Linie AB,
- Figur 2c: gemessene Farbortkoordinaten der CIE-Farbtafel in Auftragung gegen den Betrachtungswinkel eines von dem in den Figuren 2a und 2b dargestellten Lumineszenzdiodenchips emittierten Lichtes,
- Figur 2d: die Strahlungsintensität des von den in Figuren 2a und 2b dargestellten Lumineszenzdiodenchips emittierten Lichtes in Abhängigkeit von dem Beobachtungswinkel,
- Figur 3: die CIE-Farbtafel mit darin eingetragenen ausgewählten Punkten der in den Figuren 1c und 2c dargestellten Messergebnissen,
- Figur 4a: eine schematische Darstellung einer Draufsicht auf einen beispielhaften Lumineszenzdiodenchip,
- Figur 4b: eine schematische Schnittansicht des in Figur 4a dargestellten Lumineszenzdiodenchips in einem Schnitt entlang der gestrichelten Linie AB,
- Figur 5a: eine schematische Darstellung einer Draufsicht auf einen Lumineszenzdiodenchip gemäß eines zweiten Ausführungsbeispiels,
- Figur 5b: eine schematische Schnittansicht des in Figur 5a dargestellten Lumineszenzdiodenchips in einem Schnitt entlang der gestrichelten Linie AB,
- Figur 6a: eine schematische Darstellung einer Draufsicht auf einen Lumineszenzdiodenchip gemäß eines dritten Ausführungsbeispiels,
- Figur 6b: eine schematische Schnittansicht des in Figur 6a dargestellten Lumineszenzdiodenchips in einem Schnitt entlang der gestrichelten Linie AB,
- Figur 7: eine schematische Schnittansicht einer Halbleiterschichtenfolge eines beispielhaften Lumineszenzdiodenchips, und
- Figur 8: eine schematische Schnittansicht eines beispielhaften Lumineszenzdiodenchips.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht notwendigerweise als maßstabsgerecht anzusehen. Vielmehr sind einige Details der Figuren zum besseren Verständnis übertrieben groß dargestellt.

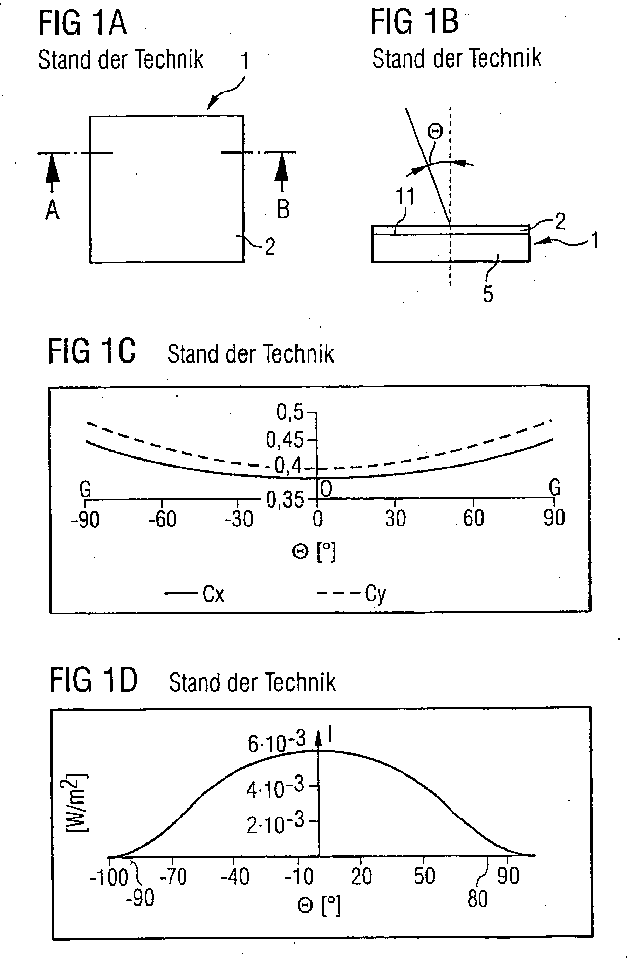

In den Figuren 1a und 1b ist ein Lumineszenzdiodenchip 1 mit einer Halbleiterschichtenfolge 5 und einer Konverterschicht 2 dargestellt, wobei letztere auf einer Hauptfläche 11 der Halbleiterschichtenfolge 5 aufgebracht ist. Die Konverterschicht 2 weist eine im wesentlichen konstante Dicke von etwa 20 *µ*m auf und erstreckt sich im wesentlichen ganzflächig über die gesamte Hauptfläche 11. Mit anderen Worten ist die Konverterschicht 2 des in den Figuren 1a und 1b dargestellten Lumineszenzdiodenchips unstrukturiert.

Der Lumineszenzdiodenchip 1 ist ein Dünnfilm-Lumineszenzdiodenchip, dessen Halbleiterschichtenfolge 5 bei Beaufschlagung mit einem Strom in Durchlassrichtung eine Primärstrahlung aus einem blauen Wellenlängenbereich emittiert, der um eine Wellenlänge von etwa 464 nm herum liegt. In der Konverterschicht 2 ist der Leuchtstoff YAG:Ce enthalten. Er ist zumindest durch einen spektralen Teilbereich der Primärstrahlung der Halbleiterschichtenfolge 5 anregbar und emittiert nach einer Anregung eine Sekundärstrahlung aus einem gelben Wellenlängenbereich.

In Figur 1c ist der Farbort bzw. sind die Farbortkoordinaten Cₓ und C_{y} der CIE-Farbtafel für eine Mischstrahlung, die von dem in den Figuren 1a und 1b dargestellten Lumineszenzdiodenchip 1 emittiert wird, in Abhängigkeit des Betrachtungswinkels θ aufgetragen.

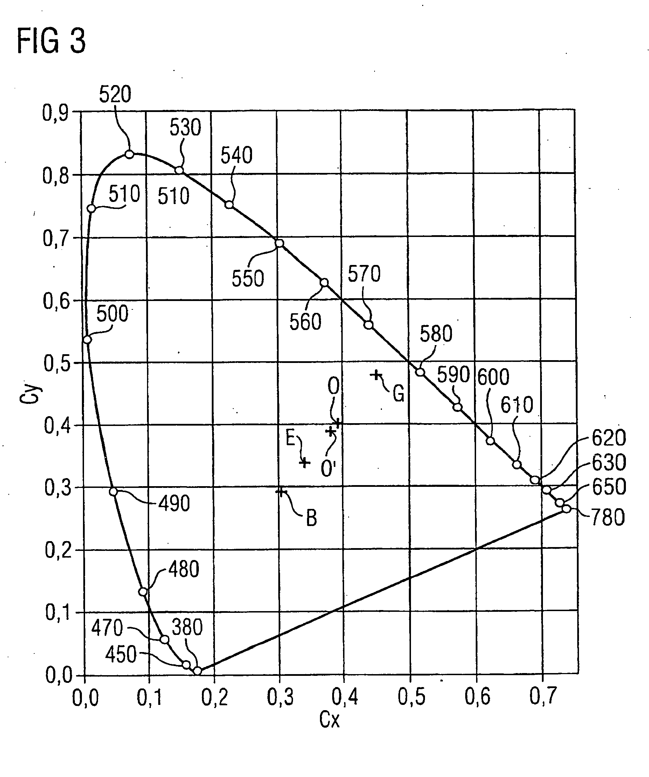

Der Farbort O für einen Betrachtungswinkel θ von 0° ist in eine in Figur 3 dargestellte CIE-Farbtafel eingetragen. Er liegt in der Nähe des Unbuntpunktes E und entspricht einem weißen Licht, dessen Farbanteile leicht zum Gelben (ungefähr 575 nm) hin verschoben sind.

Wie in Figur 1c erkennbar ist, werden die Farbortkoordinaten Cₓ und C_{y} mit größer werdendem Betrachtungswinkel θ größer, d.h. der Anteil von gelbem Licht bzw. von der Sekundärstrahlung in der Mischstrahlung nimmt mit größer werdendem Betrachtungswinkel θ zu. Der Farbort G für einen Betrachtungswinkel θ von +/- 90° ist ebenfalls in der in Figur 3 dargestellten CIE-Farbtafel eingetragen. Licht eines derartigen Farbortes ist im wesentlichen als gelbes Licht wahrnehmbar, d.h. der Lumineszenzdiodenchip emittiert ein Licht, das für relativ geringe Betrachtungswinkel θ um die 0° herum zwar weiß erscheint, das jedoch für größer werdende Betrachtungswinkel θ, insbesondere ab +/- 60° in zunehmendem Maße gelb erscheint.

In Figur 1d ist eine von dem Lumineszenzdiodenchip 1 emittierte Strahlungsintensität I in Abhängigkeit von dem Betrachtungswinkel θ aufgetragen. Bei einem Betrachtungswinkel θ von etwa +/- 60° ist die emittierte Strahlungsintensität I auf etwa die Hälfte des maximalen Wertes abgefallen, den sie für einen Betrachtungswinkel von 0° aufweist. Für einen Betrachtungswinkel θ von ungefähr +/- 90° beträgt die Strahlungsintensität I nur noch etwa ein Zwanzigstel der maximalen Strahlungsintensität, d.h. die unter großen Betrachtungswinkeln θ gelblich erscheinende Mischstrahlung wird mit einer deutlich geringeren Strahlungsintensität emittiert als die Mischstrahlung, die unter einem Betrachtungswinkel θ um die 0° weiß erscheint. Dennoch ist der gelblich erscheinende Anteil der Mischstrahlung deutlich wahrnehmbar, was bei manchen Anwendungen nicht erwünscht sein kann.

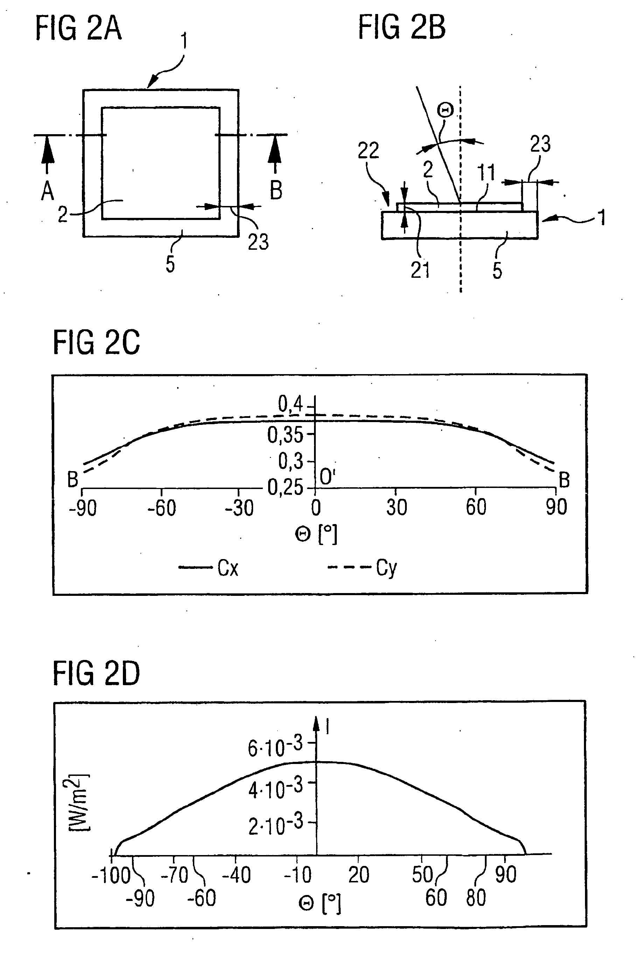

In den Figuren 2a und 2b ist ein Lumineszenzdiodenchip 1 dargestellt, der als einzigen wesentlichen Unterschied zu dem vorhergehend anhand der Figuren 1a und 1b erläuterten Lumineszenzdiodenchip eine strukturierte Konverterschicht 2 aufweist. Die Hauptfläche 11 der Halbleiterschichtenfolge 5 weist entlang eines Randes der Halbleiterschichtenfolge 5 rundum eine Strukturierung 22 in Form eines Streifens auf, der frei von der Konverterschicht 2 ist. Der Streifen weist eine Breite 23 auf, die etwa einem Zehntel der Chipkantenlänge des Lumineszenzdiodenchips 1 entspricht, wobei die Chipkantenlänge ungefähr 300 *µ*m beträgt. Diese Strukturierung 22 hat einen signifikanten Einfluss auf die Winkelabhängigkeit des Farborts des von dem Lumineszenzdiodenchip 1 emittierten Lichtes bzw. der emittierten Mischstrahlung, wie anhand der Figuren 2c bis 3 veranschaulicht wird.

In den Figuren 2c und 3 ist zu sehen, dass der Farbort O' für einen Betrachtungswinkel θ von 0° gegenüber dem Farbort O des in Figur 1c dargestellten Spektrums geringfügig zum Blauen (etwa 470 nm) hin verschoben ist.

Für größere Betrachtungswinkel θ macht sich der Einfluss der Strukturierung der Konverterschicht 2 dahingehend deutlicher bemerkbar, dass die Farbkoordinaten Cₓ und C_{y} im Gegensatz zu dem in Figur 1c dargestellten Farbortspektrum geringer werden. D.h. aufgrund der Strukturierung in Form des Streifens am Rand des Lumineszenzdiodenchips, der frei von der Konverterschicht 2 ist, verschiebt sich der Farbort für größer werdende Betrachtungswinkel θ nicht zum Gelben, wie das bei der unstrukturierten Konverterschicht 2 der Fall ist, sondern zum Blauen.

Der Farbort B des in Figur 2c dargestellten Farbortspektrums für einen Betrachtungswinkel θ von +/- 90° ist in der in Figur 3 dargestellten CIE-Farbtafel eingetragen. Er ist relativ zum Farbort O' für einen Betrachtungswinkel θ von 0° deutlich zum Blauen hin verschoben, liegt jedoch noch in einem Bereich, der im wesentlichen als weiß empfunden wird.

Durch eine entsprechende Verkleinerung der Breite 23 des Streifens kann erreicht werden, dass der Farbort für einen Betrachtungswinkel θ von +/- 90° näher an den Farbort für einen Betrachtungswinkel von 0° heranrückt, wogegen eine Verbreiterung des Streifens diesen Farbort noch weiter zum Blauen verschiebt. Ein Maß der Abhängigkeit des resultierenden Farbortes von dem Abstrahlwinkel kann somit in einem weiten Bereich variiert und insbesondere auch, verglichen mit einer unstrukturierten Konverterschicht, signifikant verringert werden. Hierfür weist der Streifen beispielsweise eine Breite auf, die größer als oder gleich 3% und kleiner als oder gleich 7% der Kantenlänge des Lumineszenzdiodenchips ist. Die Breite des Streifens beträgt z.B. 18 *µ*m.

In Figur 2d ist eine von dem anhand den Figuren 2a und 2b erläuterten Lumineszenzdiodenchip 1 emittierte Strahlungsintensität I in Abhängigkeit von dem Betrachtungswinkel θ aufgetragen. Im Unterschied zu der in Figur 1d aufgetragenen Strahlungsintensität des in den Figuren 1a und 1b dargestellten Lumineszenzdiodenchips mit der unstrukturierten Konverterschicht beträgt die emittierte Strahlungsintensität I bei einem Betrachtungswinkel θ von etwa +/- 60° mehr als die Hälfte des maximalen Wertes, den sie für einen Betrachtungswinkel θ von 0° aufweist. Für einen Betrachtungswinkel θ von ungefähr +/- 90° beträgt die Strahlungsintensität I etwa ein Viertel der maximalen Strahlungsintensität, während die entsprechende Strahlungsintensität I bei dem in Figur 1d dargestellten Diagramm nur ein Zwanzigstel beträgt. Demnach scheint die Strukturierung der Konverterschicht nicht nur einen Einfluss auf die Winkelabhängigkeit des Farborts, sondern auch einen Einfluss auf die Winkelabhängigkeit der emittierten Strahlungsintensität zu haben.

Die Lumineszenzdiodenchips wurden beide zur Durchführung der Farborts- und Intensitätsmessungen mit einem Strom von 20 mA beaufschlagt. Die Dicke der Konverterschicht beträgt jeweils etwa 20 *µ*m und die Konverterschicht hat jeweils eine im Wesentlichen gleiche Zusammensetzung. Wie vorhergehend bereits erwähnt, weist die Konverterschicht ein mit Cer dotiertes Yttrium-Aluminium-Granat als Leuchtstoff auf, der bei geeigneter Anregung eine Sekundärstrahlung aus einem gelben Wellenlängenbereich emittiert. Als Matrixmaterial für den Leuchtstoff ist beispielsweise Silikon in der Konverterschicht enthalten. Der Leuchtstoff ist mit einem Anteil von etwa 30 Vol. % in der Konverterschicht enthalten. Eine mittlere Korngröße des Leuchtstoffs beträgt z.B. zwischen einschließlich 2 und einschließlich 4 *µ*m.

Die strukturierte Konverterschicht wird beispielsweise mittels eines Siebdruckverfahrens strukturiert auf die Hauptfläche aufgebracht. Hierzu wird eine Halbleiterschichtenfolge z.B. in Form eines Wafers für eine Vielzahl von Lumineszenzdiodenchips bereitgestellt. Zum Aufbringen der Konverterschicht wird ein Sieb mit einer Vielzahl von Löchern verwendet, die z.B. eine Öffnung mit einer Ausdehnung von etwa 20 µm aufweisen. In Bereichen, in denen keine oder eine dünnere Konverterschicht auf die Hauptfläche der Halbleiterschichtenfolge aufgebracht werden soll, weist das Sieb keine Löcher auf oder sind die Löcher des Siebs verschlossen, z.B. mittels Abkleben. Nachfolgend wird eine Konvertermasse durch die Löcher des Siebs gestrichen und auf diese Weise eine im Wesentlichen gleichmäßig dicke Konverterschicht auf die gewünschten Bereiche der Hauptfläche aufgebracht. Der Wafer kann auch bereits vereinzelt sein, in welchem Fall auch auf Seitenflächen der Halbleiterschichtenfolgen eine Konverterschicht aufgebracht werden kann.

Mittels des vorhergehend beschriebenen Siebdruckverfahrens ist es auch möglich, die Konverterschicht derart aufzubringen, dass sie in Teilbereichen eine geringere Dicke aufweist. Dies kann z.B. mittels einer Konvertermasse mit einer geeignet niedrigen Viskosität erreicht werden, die nach dem Aufbringen zumindest teilweise auch auf diejenigen Bereiche der Hauptfläche fließt, auf die sie nicht direkt aufgebracht wird.

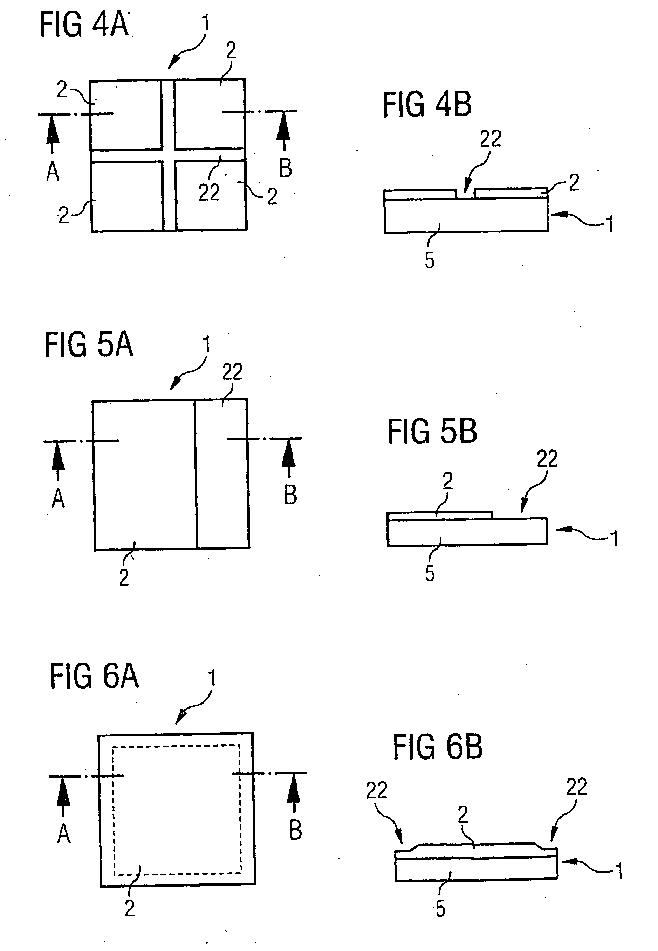

Auf diese Weise lässt sich die Konverterschicht z.B. mit einer Struktur 22 aufbringen, wie sie in den Figuren 6a und 6b dargestellt ist. Die Struktur 22 ist derart ausgebildet, dass auf einem Streifen der Hauptfläche 11, der entlang des Randes der Halbleiterschichtenfolge 5 verläuft, die Konverterschicht 2 mit einer gegenüber ihren übrigen auf der Hauptfläche angeordneten Bereichen geringeren Dicke aufgebracht ist.

Altnernativ zu einem Siebdruckverfahren ist es möglich, die Konverterschicht zunächst ganzflächig in einer gleichmäßig dicken Schicht aufzubringen und sie nachfolgend zu strukturieren. Das Strukturieren erfolgt z.B. mittels eines lithographischen Verfahrens, bei dem die Konverterschicht in gewünschten Bereichen zumindest teilweise durch eine Maske hindurch mittels Ätzen entfernt wird.

Die Maske kann vorgefertigt sein, so dass sie bei dem Verfahren auf die Hauptfläche der Halbleiterschichtenfolge aufgebracht und ausgerichtet wird. Alternativ ist z.B. auch ein photolithographisches Verfahren möglich, bei dem die Maske durch Aufbringen und Strukturieren eines Maskenmaterials gebildet wird. Als Maskenmaterial wird z.B. ein photosensitives Material verwendet, das zum Strukturieren in zu entfernenden Bereichen belichtet, entwickelt und entfernt wird. Zum Ätzen wird ein geeignetes Ätzmittel verwendet.

In den Figuren 4a und 4b ist ein Beispiel eines Lumineszenzdiodenchips 1 dargestellt. Bei diesem ist die Konverterschicht 2 derart strukturiert, dass die Hauptfläche 11 entlang von zwei sich senkrecht kreuzenden Streifen, die in der Mitte der Hauptfläche 11 jeweils parallel zu zwei Kanten der Halbleiterschichtenfolge 5 verlaufen, frei von der Konverterschicht ist, so dass die Konverterschicht 2 vier voneinander getrennte Bereiche auf der Hauptfläche 11 aufweist. Mit einer derartigen Strukturierung 22 lässt sich der resultierende Farbort insbesondere für kleine Betrachtungswinkel einstellen.

Der in den Figuren 5a und 5b dargestellte Lumineszenzdiodenchip weist auf der Hauptfläche einen einzigen Streifen entlang einer Kante der Halbleiterschichtenfolge 5 auf, der frei von der Konverterschicht 2 ist. Der Streifen weist eine Breite auf, die etwa einem Drittel der Kantenlänge der Halbleiterschichtenfolge 5 entspricht. Durch eine derartige Strukturierung 22 lässt sich ein Farbortspektrum des Lumineszenzdiodenchips erreichen, bei dem in einem Halbraum die Primärstrahlung dominiert und in den anderen Halbraum ein im wesentlichen ausgewogenes Mischlicht mit einem großen Anteil an Sekundärstrahlung emittiert wird. Dadurch lässt sich durch einen einzigen Halbleiterchip Licht von mehreren Farbortbereichen gleichzeitig erzeugen. Dies kann insbesondere für Anwendungen interessant sein, bei denen neben rein funktionellen Aspekten, die z.B. weißes Licht erforderlich machen, auch ästhetische Aspekte eine Rolle spielen.

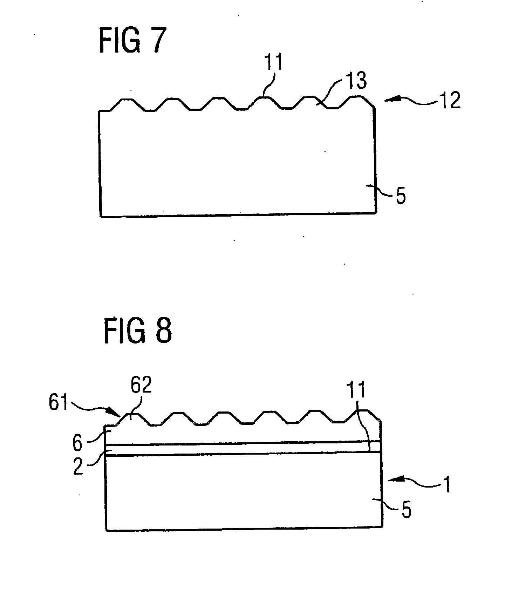

Zusätzlich zu einer gezielt strukturierten Konverterschicht weisen die Lumineszenzdiodenchips z.B. eine Halbleiterschichtenfolge auf, in der Auskoppelstrukturen derart ausgebildet sind, dass eine Abhängigkeit der Intensität der Primärstrahlung von dem Betrachtungswinkel eingestellt ist, siehe Figur 7. Die Auskoppelstrukturen 12 umfassen z.B. prismenartige Elemente 13. Sie werden z.B. mittels eines photolithographischen Prozesses ausgebildet. Durch die Auskoppelstrukturen 12 kann z.B. eine Vorzugsabstrahlrichtung der Primärstrahlung beeinflusst werden, was wiederum auch Einfluss auf die Winkelabhängigkeit des resultierenden Farbortspektrums hat.

Zusätzlich oder alternativ weisen die Lumineszenzdiodenchips eine Auskoppelschicht 6 auf, die auf der Konverterschicht 2 angeordnet ist und die mit Auskoppelstrukturen 61 versehen ist. Auch diese Auskoppelstrukturen 61 weisen beispielsweise prismenartige Elemente 62 auf. Die Auskoppelschicht 6 weist z.B. Silikon auf oder besteht aus diesem. Die Strukturen werden z.B. mittels eines photolithografischen Prozesses oder mittels eines Stempels ausgebildet.

Die prismenartige Elemente 62, 13 der Auskoppelstrukturen 61, 12 bzw. Strukturelemente der Auskoppelstrukturen 61, 12 der Halbleiterschichtenfolge und/oder der Auskoppelschicht haben z.B. eine laterale Ausdehnung zwischen einschließlich 50 nm und einschließlich 5 *µ*m, wobei die Ausdehnung bevorzugt maximal 1 *µ*m groß ist.

Die Halbleiterschichtenfolge ist beispielsweise auf Nitrid-Verbindungshalbleitern basierend, d.h. sie enthält vorzugsweise AlₓIn_{y}Ga_{1-x-y}N, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im wesentlichen nicht ändern. Der Einfachheit halber beinhaltet obige Formel nur die wesentlichen Bestandteile des Kristallgitters (A1, In, Ga, N), auch wenn diese teilweise durch geringe Mengen weiterer Stoffe ersetzt sein können.

Die Halbleiterschichtenfolge emittiert bei Beaufschlagung mit einem Strom beispielsweise eine elektromagnetische Strahlung aus einem blauen oder ultravioletten Wellenlängenbereich. Sie kann z.B. einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Solche Strukturen sind dem Fachmann bekannt und werden von daher an dieser Stelle nicht näher erläutert.

Die Konverterschicht kann sowohl einen als auch mehrere verschiedene Leuchtstoffe aufweisen. Sie kann auch mehrschichtig ausgebildet sein, wobei jede Schicht einen unterschiedlichen Leuchtstoff aufweisen kann. Als Leuchtstoff sind beispielsweise anorganische Leuchtstoffe geeignet, wie mit seltenen Erden, insbesondere mit Ce oder Tb, dotierte Granate, die bevorzugt eine Grundstruktur A₃B₅O₁₂ aufweisen, oder organische Leuchtstoffe, wie Perylen-Leuchtstoffe. Weitere geeignete Leuchtstoffe sind beispielsweise in der WO 98/12757 und in der WO 01/65613 A1 aufgeführt.

## Patentansprüche

1. Lumineszenzdiodenchip mit einer Halbleiterschichtenfolge, die geeignet ist, eine elektromagnetische Primärstrahlung zu emittieren, und mit einer Konverterschicht, die auf mindestens einer Hauptfläche der Halbleiterschichtenfolge aufgebracht ist und die mindestens einen Leuchtstoff aufweist, der geeignet ist, einen Teil der Primärstrahlung in eine Sekundärstrahlung zu konvertieren, die einen verglichen mit der Primärstrahlung zumindest teilweise unterschiedlichen Wellenlängenbereich aufweist, wobei sich zumindest ein Teil der Sekundärstrahlung und zumindest ein Teil der unkonvertierten Primärstrahlung zu einer Mischstrahlung mit einem resultierenden Farbort überlagern,
**dadurch gekennzeichnet,**
**dass** die Konverterschicht gezielt zur Einstellung einer Abhängigkeit des resultierenden Farbortes von einem Betrachtungswinkel an einem Rand des Lumineszenzdiodenchips derart strukturiert ist,
**dass** die Hauptfläche einen Streifen aufweist, der entlang dem Rand des Lumineszenzdiodenchips verläuft und der frei von der Konverterschicht ist oder in dem die Konverterschicht gegenüber ihren übrigen auf der Hauptfläche angeordneten Bereichen eine verringerte Dicke aufweist, wobei der Streifen eine Breite von größer als 0 µm und von maximal einem Zehntel einer Kantenlänge des Lumineszenzdiodenchips aufweist.

2. Lumineszenzdiodenchip gemäß Anspruch 1,
**dadurch gekennzeichnet, dass**
die Konverterschicht derart strukturiert ist, dass die Abhängigkeit des resultierenden Farbortes von dem Betrachtungswinkel, verglichen mit einer unstrukturierten Konverterschicht, verringert ist.

3. Lumineszenzdiodenchip gemäß einem der vorhergehenden Ansprüche,
**dadurch gekennzeichnet, dass**
der Lumineszenzdiodenchip ein Dünnfilm-Lumineszenzdiodenchip ist.

4. Lumineszenzdiodenchip gemäß einem der vorhergehenden Ansprüche,
**dadurch gekennzeichnet, dass**
die Konverterschicht Silikon aufweist.

5. Lumineszenzdiodenchip gemäß einem der vorhergehenden Ansprüche,
**dadurch gekennzeichnet, dass**
die Konverterschicht größer als 0 µm und maximal 50 µm dick ist.

6. Verfahren zum Herstellen eines Lumineszenzdiodenchips mit einer Halbleiterschichtenfolge, die geeignet ist, eine elektromagnetische Primärstrahlung zu emittieren, und mit einer Konverterschicht, die auf mindestens einer Hauptfläche der Halbleiterschichtenfolge aufgebracht ist und die mindestens einen Leuchtstoff aufweist, der geeignet ist, einen Teil der Primärstrahlung in eine Sekundärstrahlung zu konvertieren, die einen gegenüber einer konvertierten Primärstrahlung zumindest teilweise unterschiedlichen Wellenlängenbereich aufweist, wobei sich zumindest ein Teil der Sekundärstrahlung und zumindest ein Teil der unkonvertierten Primärstrahlung zu einer Mischstrahlung mit einem resultierenden Farbort überlagern,
und die Halbleiterschichtenfolge bereitgestellt wird und die Hauptfläche der Halbleiterschichtenfolge mit der Konverterschicht versehen wird,
**dadurch gekennzeichnet,**
**dass** die Konverterschicht gezielt zur Einstellung einer Abhängigkeit des resultierenden Farbortes von einem Betrachtungswinkel an einem Rand des Lumineszenzdiodenchips derart strukturiert wird,
**dass** die Hauptfläche einen Streifen aufweist, der entlang dem Rand des Lumineszenzdiodenchips verläuft und der frei von der Konverterschicht ist oder in dem die Konverterschicht gegenüber ihren übrigen auf der Hauptfläche angeordneten Bereichen eine verringerte Dicke aufweist, wobei der Streifen eine Breite von größer als 0 µm und von maximal einem Zehntel einer Kantenlänge des Lumineszenzdiodenchips aufweist.

7. Verfahren gemäß Anspruch 6,
**dadurch gekennzeichnet, dass**
die Konverterschicht durch ein strukturiertes Aufbringen mittels eines Siebdruckverfahrens strukturiert wird.

8. Verfahren gemäß Anspruch 6,
**dadurch gekennzeichnet, dass**
die Konverterschicht auf die Hauptfläche aufgebracht und nachfolgend strukturiert wird.

9. Verfahren nach Anspruch 8,
**dadurch gekennzeichnet, dass**
die Konverterschicht mittels eines lithographischen Prozesses strukturiert wird.

## Claims

1. Luminescence diode chip comprising a semiconductor layer sequence suitable for emitting an electromagnetic primary radiation, and comprising a converter layer, which is applied on at least one main surface of the semiconductor layer sequence and which comprises at least one phosphor suitable for converting a part of the primary radiation into a secondary radiation having an at least partly different wavelength range compared with the primary radiation, wherein at least one part of the secondary radiation and at least one part of the unconverted primary radiation are superimposed to form a mixed radiation having a resulting colour locus,
**characterized in that**
the converter layer is structured - in a targeted manner for setting a dependence of the resulting colour locus on a viewing angle - at an edge of the luminescence diode chip in such a way
that the main surface has a strip which runs along the edge of the luminescence diode chip and which is free of the converter layer or in which the converter layer has a reduced thickness compared with its other regions arranged on the main surface, wherein the strip has a width of greater than 0 µm and of a maximum of one tenth of an edge length of the luminescence diode chip.

2. Luminescence diode chip according to claim 1,
**characterized in that**
the converter layer is structured in such a way that the dependence of the resulting colour locus on the viewing angle, compared with an unstructured converter layer, is reduced.

3. Luminescence diode chip according to either of the preceding claims,
**characterized in that**
the luminescence diode chip is a thin-film luminescence diode chip.

4. Luminescence diode chip according to any of the preceding claims,
**characterized in that**
the converter layer comprises silicone.

5. Luminescence diode chip according to any of the preceding claims,
**characterized in that**
the converter layer has a thickness of greater than 0 µm and maximum of 50 µm.

6. Method for producing a luminescence diode chip comprising a semiconductor layer sequence suitable for emitting an electromagnetic primary radiation, and comprising a converter layer, which is applied on at least one main surface of the semiconductor layer sequence and which comprises at least one phosphor suitable for converting a part of the primary radiation into a secondary radiation having an at least partly different wavelength range compared with a converted primary radiation, wherein at least one part of the secondary radiation and at least one part of the unconverted primary radiation are superimposed to form a mixed radiation having a resulting colour locus,
and the semiconductor layer sequence is provided and the main surface of the semiconductor layer sequence is provided with the converter layer,
**characterized in that**
the converter layer is structured - in a targeted manner for setting a dependence of the resulting colour locus on a viewing angle - at an edge of the luminescence diode chip in such a way
that the main surface has a strip which runs along the edge of the luminescence diode chip and which is free of the converter layer or in which the converter layer has a reduced thickness compared with its other regions arranged on the main surface, wherein the strip has a width of greater than 0 µm and of a maximum of one tenth of an edge length of the luminescence diode chip.

7. Method according to claim 6,
**characterized in that**
the converter layer is structured by structured application by means of a screen printing method.

8. Method according to claim 6,
**characterized in that**
the converter layer is applied to the main surface and subsequently structured.

9. Method according to claim 8,
**characterized in that**
the converter layer is structured by means of a lithographic process.

## Revendications

1. Puce de diode électroluminescente dotée d'une séquence de couches en semiconducteur, laquelle est adaptée pour émettre un rayonnement primaire électromagnétique, et dotée d'une couche de conversion, laquelle est appliquée sur au moins une surface principale de la séquence de couches en semiconducteur et présente au moins une substance luminescente qui est adaptée pour convertir une partie du rayonnement primaire en un rayonnement secondaire, lequel présente une plage de longueurs d'onde au moins partiellement différente en comparaison du rayonnement primaire, au moins une partie du rayonnement secondaire et au moins une partie du rayonnement primaire non converti se superposant pour former un rayonnement mélangé ayant une localisation chromatique résultante,
**caractérisée en ce**
**que** la couche de conversion est structurée - de manière ciblée pour établir une dépendance de la localisation chromatique résultante à un angle d'observation - à un bord de la puce de diode électroluminescente de telle sorte
**que** la surface principale présente une bande qui s'étend le long du bord de la puce de diode électroluminescente et qui est dépourvue de la couche de conversion ou dans laquelle la couche de conversion présente une épaisseur réduite par rapport à ses autres zones disposées sur la surface principale, la bande présentant une largeur supérieure à 0 µm et égale au maximum à un dixième de la longueur d'un bord de la puce de diode électroluminescente.

2. Puce de diode électroluminescente selon la revendication 1,
**caractérisée en ce**
**que** la couche de conversion est structurée de telle sorte que la dépendance de la localisation chromatique résultante à l'angle d'observation est réduite en comparaison d'une couche de conversion non structurée.

3. Puce de diode électroluminescente selon l'une des revendications précédentes,
**caractérisée en ce**
**que** la puce de diode électroluminescente est une puce de diode électroluminescente à film mince.

4. Puce de diode électroluminescente selon l'une des revendications précédentes,
**caractérisée en ce**
**que** la couche de conversion présente de la silicone.

5. Puce de diode électroluminescente selon l'une des revendications précédentes,
**caractérisée en ce**
**que** la couche de conversion a une épaisseur supérieure à 0 µm et au maximum de 50 µm.

6. Procédé de fabrication d'une puce de diode électroluminescente dotée d'une séquence de couches en semiconducteur, laquelle est adaptée pour émettre un rayonnement primaire électromagnétique, et dotée d'une couche de conversion, laquelle est appliquée sur au moins une surface principale de la séquence de couches en semiconducteur et présente au moins une substance luminescente qui est adaptée pour convertir une partie du rayonnement primaire en un rayonnement secondaire, lequel présente une plage de longueurs d'onde au moins partiellement différente en comparaison d'un rayonnement primaire converti, au moins une partie du rayonnement secondaire et au moins une partie du rayonnement primaire non converti se superposant pour former un rayonnement mélangé ayant une localisation chromatique résultante,
et la séquence de couches en semiconducteur étant fournie et la surface principale de la séquence de couches en semiconducteur étant dotée de la couche de conversion,
**caractérisé en ce**
**que** la couche de conversion est structurée - de manière ciblée pour établir une dépendance de la localisation chromatique résultante à un angle d'observation - à un bord de la puce de diode électroluminescente, de telle sorte
**que** la surface principale présente une bande qui s'étend le long du bord de la puce de diode électroluminescente et qui est dépourvue de la couche de conversion ou dans laquelle la couche de conversion présente une épaisseur réduite par rapport à ses autres zones disposées sur la surface principale, la bande présentant une largeur supérieure à 0 µm et égale au maximum à un dixième de la longueur d'un bord de la puce de diode électroluminescente.

7. Procédé selon la revendication 6,
**caractérisé en ce**
**que** la couche de conversion est structurée par une application structurée au moyen d'un procédé de sérigraphie.

8. Procédé selon la revendication 6,
**caractérisé en ce**
**que** la couche de conversion est appliquée sur la surface principale et ensuite structurée.

9. Procédé selon la revendication 8,
**caractérisé en ce**
**que** la couche de conversion est structurée au moyen d'un procédé lithographique.
